# EUROPÄISCHE PATENTSCHRIFT

(11) **EP 3 917 294 B1**
(45) Veröffentlichungstag und Bekanntmachung des Hinweises auf die Patenterteilung: **15.02.2023**
(21) Anmeldenummer: 21175592.1
(22) Anmeldetag: 25.05.2021
(51) Int. Cl.: H05K 1/18, H05K 1/02, H05K 3/36, H05K 3/40, H01R 12/73, H01R 24/50, H01R 12/91

(54) **LEITERPLATTE MIT EINEM STECKVERBINDERANSCHLUSS SOWIE ELEKTRISCHE STECKVERBINDERANORDNUNG MIT EINER SOLCHEN LEITERPLATTE**
CIRCUIT BOARD WITH A CONNECTOR TERMINAL AND ELECTRICAL CONNECTOR ASSEMBLY COMPRISING SUCH A CIRCUIT BOARD
CARTE DE CIRCUIT IMPRIMÉ DOTÉ D'UN PORT DE CONNECTEUR ENFICHABLE, AINSI QUE AGENCEMENT DE CONNECTEUR ENFICHABLE ÉLECTRIQUE DOTÉ D'UNE TELLE CARTE DE CIRCUIT IMPRIMÉ

(30) Priorität: 26.05.2020 DE 102020114114
(43) Veröffentlichungstag der Anmeldung: 01.12.2021
(73) Patentinhaber: IMS Connector Systems GmbH, 79843 Löffingen (DE)
(72) Erfinder: Kreklow, Kevin, 79112 Freiburg (DE)
(74) Vertreter: Westphal, Mussgnug & Partner Patentanwälte mbB

(56) Entgegenhaltungen:
- EP-A1- 2 244 291
- WO-A1-2020/099375
- DE-A1-102005 002 707
- DE-A1-102018 100 557
- US-A1- 2003 013 326
- US-A1- 2009 223 708

## Beschreibung

Die Erfindung betrifft eine Leiterplatte mit einem Steckverbinderanschluss zur Direktkontaktierung mit einem Steckverbinder sowie eine elektrische Steckverbinderanordnung mit einer solchen Leiterplatte und einem direkt mit dieser Leiterplatte verbundenen Steckverbinder.

Zur elektrischen Verbindung von benachbarten und parallel ausgerichteten Leiterplatten werden Steckverbinder verwendet, die an gegenüberliegenden Flächen der Leiterplatten befestigt werden. Solche als B2B(board-to-board)-Verbinder bezeichnete Steckverbinder bestehen aus drei Steckerteilen, nämlich zwei jeweils an der Leiterplatte befestigten Buchsen und einem Adapter (auch als Bullet bezeichnet), welcher an den beiden Enden jeweils als Stecker ausgebildet ist. Mit einem solchen Adapter lässt sich nicht nur ein Toleranzausgleich hinsichtlich des Abstands der zu verbindenden Leiterplatten voneinander ausgleichen, sondern auch ein lateraler Achsversatz bezüglich den Längsachsen der beiden Buchsen. Als Nachteil solcher B2B-Steckverbinder lässt sich deren Dreiteiligkeit ansehen.

Ein elektrischer Steckverbinder, welcher zusammen mit einem Gegensteckverbinder eine B2B-Steckverbindung realisiert, ist bspw. aus der DE 10 2018 113 278 B3 bekannt. Diese bekannte B2B-Steckverbindung besteht lediglich aus zwei Steckerteilen, nämlich dem elektrischen Steckverbinder und dem Gegensteckverbinder. Der elektrische Steckverbinder wird mittels eines endseitig an einer ein Außenleiter darstellenden Hülse angeordneten und sich trichterförmig aufweitenden Flansches mit einer Leiterplatte mechanisch und elektrisch verbunden, während der Gegensteckverbinder ebenso mittels eines endseitig an einer ein Außenleiter darstellenden Hülse angeordneten und sich trichterförmig aufweitenden Flansches mit einer weiteren Leiterplatte mechanisch und elektrisch verbunden. Ein den lateraler Achsversatz kompensierender Toleranzausgleich wird in dem elektrischen Steckverbinder mittels eines flexiblen Biegeabschnittes von dessen Hülse realisiert.

EP 2 244 291 A1 offenbart eine Leiterplatte mit einem Steckverbinderanschluss zur Direktkontaktierung mit einem Steckverbinder, wobei der Steckverbinderanschluss auf der Vorderseite der Leiterplatte ausgebildet ist mit einer in dem Einsteckraum angeordneten Kontaktzone eines Außenleiters zur Kontaktierung eines Außenleiters des Steckverbinders.

Der Erfindung liegt die Aufgabe zugrunde, eine Leiterplatte zu schaffen, mit welcher eine Direktkontaktierung mit einem elektrischen Steckverbinder ermöglicht wird. Ferner ist es Aufgabe der Erfindung, eine elektrische Steckverbinderanordnung mit dieser Leiterplatte zur Herstellung einer Direktkontaktierung mit einem elektrischen Steckverbinder anzugeben. Die erstgenannte Aufgabe wird gelöst durch eine Leiterplatte mit den Merkmalen des Patentanspruchs 1.

Eine solche Leiterplatte umfasst einen Steckverbinderanschluss zur Direktkontaktierung mit einem Steckverbinder, wobei der Steckverbinderanschluss auf der Vorderseite der Leiterplatte ausgebildet ist mit
- einem in einer Sacklochbohrung unter Bildung eines kreisringzylinderischen Einsteckraums zentrisch angeordneten Kontaktstift, welcher eine Innenbohrung mit einer ersten Kontaktzone eines Innenleiter zur Kontaktierung eines Innenleiters des Steckverbinders aufweist, und
- einer in dem Einsteckraum angeordneten zweiten Kontaktzone eines Außenleiters zur Kontaktierung eines Außenleiters des Steckverbinders.

Mit einer solchen erfindungsgemäßen Leiterplatte wird der Steckverbinderanschluss direkt mit einem Steckverbinder mechanisch und elektrisch verbunden. Der Steckverbinder wird seinerseits über einen an dem gegenüberliegenden Ende von dessen Hülse angeordneten Flansch mechanisch mit einer weiteren Leiterplatte zur Realisierung einer B2B-Steckverbindung verbunden, so dass lediglich ein einziges Steckerteil hierfür erforderlich ist.

Bei dieser erfindungsgemäßen Leiterplatte übernimmt der Steckverbinderanschluss die Funktion einer Buchse für den Steckverbinder. Erfindungsgemäß weist der Steckverbinderanschluss einen Einsteckraum auf, in welchen das steckseitige Ende des Steckverbinders eingeführt wird, so dass eine mechanische und eine elektrische Verbindung zwischen den Kontaktzonen der entsprechenden Außenleiter einerseits und andererseits zwischen den Kontaktzonen der entsprechenden Innenleiter herstellbar ist.

Hierzu ist nach einer vorteilhaften Weiterbildung der Erfindung der Einsteckraum einen Kontaktabschnitt mit der zweiten Kontaktzone und einen Trichterabschnitt mit einer in Richtung der Vorderseite der Leiterplatte sich radial aufweitenden Anfasung aufweist. Vorzugsweise ist der Kontaktstift mit der Länge des Kontaktabschnittes des Einsteckraums ausgebildet. Mittels des Trichterabschnittes lässt sich das steckseitige Ende des Steckverbinders in manuell verbesserter Weise in den Einsteckraum einführen.

Nach einer weiteren bevorzugten Ausführungsform der Erfindung ist es vorgesehen, dass der Innenleiter auf eine zur Vorderseite der Leiterplatte gegenüberliegende Leiterbahnebene geführt und mit einer Leiterbahn der Leiterbahnebene elektrisch verbunden ist. Diese Leiterbahnebene kann als eingebettete Leiterbahnebene einer Mehrlagenleiterplatte realisiert sein oder eine Leiterbahnebene auf der der Vorderseite gegenüberliegenden Rückseite der Leiterplatte darstellen.

Weiterhin ist es vorteilhaft, wenn nach einer weiteren Ausführungsform der Erfindung die zweite Kontaktzone zumindest auf der äußeren Mantelfläche des kreisringzylindrischen Einsteckraums angeordnet ist. Damit lässt sich ein sicherer elektrischer Kontakt zur einen Außenleiter darstellenden Hülse eines Steckverbinders sicherstellen, da in der Regel dieser elektrische Kontakt mittels eines einen umlaufenden Wulst aufweisenden federnden Abschnittes der Hülse realisiert wird.

Des Weiteren ist es weiterbildungsgemäß vorteilhaft, wenn der Außenleiter auf eine zur Vorderseite der Leiterplatte gegenüberliegenden Leiterbahnebene geführt und mit einer Leiterbahn dieser Leiterbahnebene elektrisch verbunden ist. Diese Leiterbahnebene kann als eingebettete Leiterbahnebene einer Mehrlagenleiterplatte realisiert sein oder eine Leiterbahn auf der der Vorderseite gegenüberliegenden Rückseite der Leiterplatte darstellen.

Um die manuelle Handhabung zum Einführen des steckseitigen Endes des Steckverbinders in den Steckverbinderanschluss ist die Innenbohrung des Kontaktstiftes endseitig mit einer sich radial aufweitenden Anfasung ausgebildet.

Um einen sicheren mechanischen und elektrischen Kontakt des Steckverbinders mit dem Steckverbinderanschluss der Leiterplatte sicherzustellen, ist die radiale Weite des kreisringzylindrischen Einsteckraums zur Herstellung eines federnden Steckkontaktes an die den Außenleiter des Steckverbinders bildende Hülse angepasst.

Die zweitgenannte Aufgabe wird durch eine elektrische Steckverbinderanordnung mit den Merkmalen des Patentanspruchs 9 gelöst.

Eine solche elektrische Steckverbinderanordnung mit einer erfindungsgemäßen Leiterplatte und einem mit dem Steckverbinderanschluss der Leiterplatte verbundenen Steckverbinder, zeichnet sich dadurch aus, dass
- zur Kontaktierung der ersten Kontaktzone des Steckverbinderanschlusses der Steckverbinder einen als Innenleiterstift ausgeführten Innenleiter zum Einführen in die Innenbohrung des Kontaktstiftes des Steckverbinderanschlusses aufweist,
- der Steckverbinder einen als Hülse ausgebildeten Außenleiter mit einer Kontaktzone zur Kontaktierung der zweiten Kontaktzone des Steckverbinderanschlusses aufweist, und
- der Steckverbinder einen Dielektrikumskörper mit einer Innenbohrung zur Aufnahme des Innenleiterstiftes aufweist, wobei der Dielektrikumskörper in der Hülse angeordnet ist.

Bei dieser erfindungsgemäßen elektrischen Steckverbinderanordnung ist für den Steckverbinder kein auf der Leiterplatte anzuordnender Gegensteckverbinder erforderlich, wie dies in der oben beschriebenen DE 10 2018 113 278 B3 vorgeschlagen wird. Der dort beschriebene Steckverbinder wird mit dem Steckverbinderanschluss der Leiterplatte verbunden, wobei dessen freies Ende vorzugsweise über einen Flansch von dessen Hülse direkt mit einer weiteren Leiterplatte zur Herstellung einer B2B-Steckverbindung mechanisch verbunden wird.

Die Erfindung wird nachfolgend anhand von Ausführungsbeispielen unter Bezugnahme auf die beigefügten Figuren ausführlich beschrieben. Es zeigen:
- Figur 1: eine perspektivische Darstellung einer elektrischen Steckverbinderanordnung aus einer erfindungsgemäßen Leiterplatte und einem mit derselben direktverbundenen Steckverbinder,
- Figur 2: eine Schnittdarstellung der Steckverbinderanordnung nach Figur 1, und
- Figur 3: eine Schnittdarstellung einer erfindungsgemäßen Leiterplatte mit einem Steckverbinderanschluss.

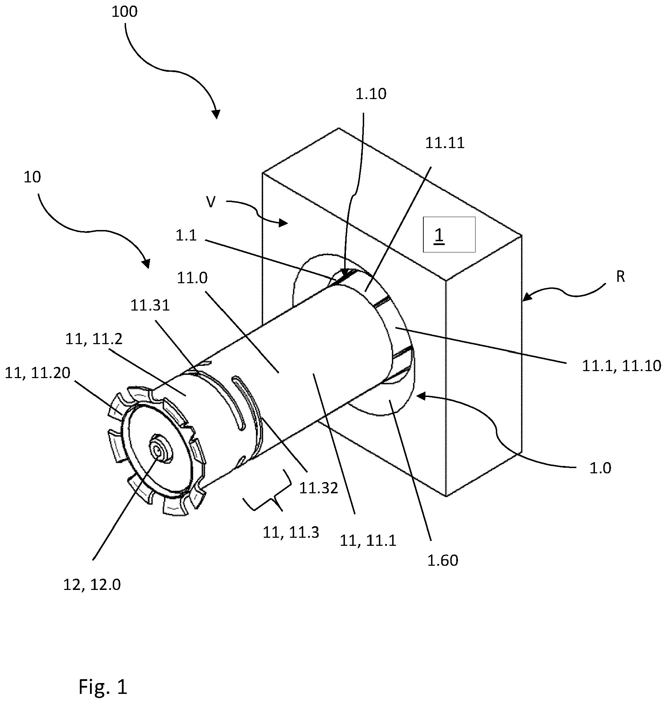

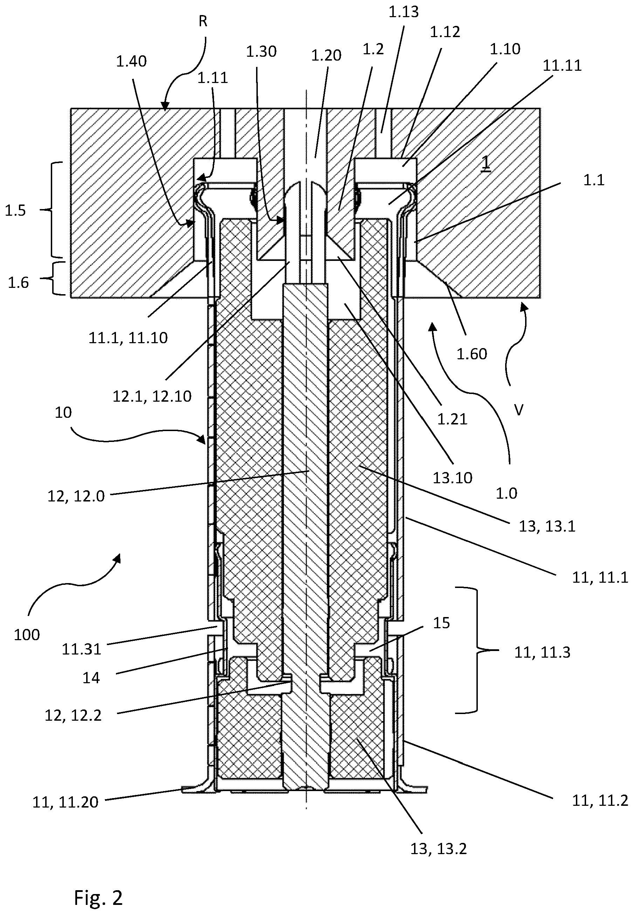

Die Figur 1 in einer perspektivischen Darstellung und Figur 2 in einer Schnittdarstellung zeigen eine elektrische Steckverbinderanordnung 100 aus einer Leiterplatte 1 mit einem Steckverbinderanschluss 1.0 und einem Steckverbinder 10, welcher über den Steckverbinderanschluss 1.0 direkt mit der Leiterplatte 1 elektrisch und mechanisch verbunden ist.

Der Steckverbinderanschluss 1.0 ist entsprechend einer an den Steckverbinder 10 angepassten Buchse in der Leiterplatte 1 ausgeführt. Der Steckverbinder 10 besteht aus einer Hülse 11 mit einem Dielektrikumskörper 13 (vgl. Figur 2), wobei im Dielektrikumskörper 13 zentrisch ein Innenleiterstift 12 als Innenleiter 12.0 des Steckverbinders 10 in einer Innenbohrung angeordnet ist. Die Hülse 11 bildet den Außenleiter 11.0 des Steckverbinders 10.

Die Hülse 11 des Steckverbinders 10 besteht aus mehreren Abschnitten, nämlich einem steckseitigen Ausgleichsabschnitt 11.1 mit einer endseitigen Kontaktzone 11.10, mit welcher der Kontakt mit dem Steckverbinderanschluss 1.0 der Leiterplatte 1 hergestellt wird, einem Halteabschnitt 11.2 mit einem endseitigen Verbindungsflansch 11.20, welcher eine mechanische und elektrische Verbindung mit einer weiteren Leiterplatte (in den Figuren nicht dargestellt) herstellbar ist, und einem Biegeabschnitt 11.3, welcher den Ausgleichsabschnitt 11.1 mit dem Halteabschnitt 11.2 verbindet. Ein den lateralen Achsversatz zwischen dem Ausgleichsabschnitt 11.1 und dem Halteabschnitt 11.2 kompensierender Toleranzausgleich wird mittels des Biegeabschnittes 11.3 realisiert, indem dieser Biegeabschnitt 11.3 der Hülse 11 mit mehreren tangential verlaufenden Schlitzen 11.31 und 11.32 ausgebildet wird.

Des Weiteren ist für die Realisierung des lateralen Achsversatzes erforderlich, dass der Dielektrikumskörper 13 des Steckverbinders 10 aus zwei Dielektrikumsteilkörpern 13.1 und 13.2 besteht. Der erste Dielektrikumsteilkörper 13.1 erstreckt sich ausgehend von der Kontaktzone 11.10 des Ausgleichsabschnittes 11.1 bis teilweise in den Biegeabschnitt 11.3 hinein, während der zweite Dielektrikumskörper 13.2 sich an den ersten Dielektrikumskörper 13.1 unter Bildung eines Spaltes 15 anschließt und sich in den Bereich des Halteabschnittes 11.2 erstreckt. Der Biegeabschnitt 11.3 wird von einer Innenhülse 14 überdeckt, ohne die Biegsamkeit des Biegeabschnittes 11.3 einzuschränken.

Schließlich ist für die Realisierung des lateralen Achsversatzes auch eine Anpassung des Innenleiterstiftes 12 erforderlich. Hierzu weist dieser Innenleiterstift 12 im Bereich des Spaltes 15 eine Querschnittsverjüngung 12.2 auf, die als Nut ausgeführt ist.

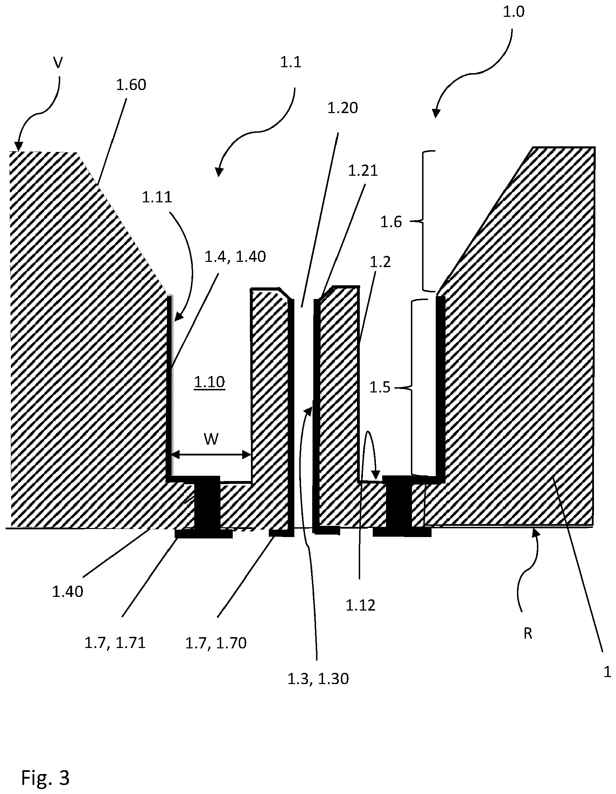

Gemäß den Figuren 2 und 3 ist der Steckverbinderanschluss 1.0 ausgehend von einer Vorderseite V der Leiterplatte 1 als Sacklochbohrung 1.1 realisiert, wobei die Sacklochbohrung 1.1 mit einer Anfasung 1.60 versehen ist, so dass sich eine trichterförmige Öffnung einstellt. Zentral in der Sacklochbohrung 1.1 ist ein Kontaktstift 1.2 angeordnet, welcher von einem kreisringzylindrischen Einsteckraum 1.10 umschlossen wird. Somit besteht die Sacklochbohrung 1.1 ausgehend vom Boden 1.12 der Sacklochbohrung 1.1 aus einem Kontaktabschnitt 1.5, welcher den Einsteckraum 1.10 bildet, und einem Trichterabschnitt 1.6 mit der Anfasung 1.60. Die Länge des über dem Boden 1.12 stehenden Kontaktstiftes 1.2 entspricht damit der Höhe des Kontaktabschnittes 1.5.

Der Kontaktstift 1.2 weist eine mit einer Anfasung 1.21 versehenen Innenbohrung 1.20 mit einer ersten Kontaktzone 1.30 als Innenleiter 1.3 des Steckverbinderanschlusses 1.0 zur Kontaktierung des Innenleiters 12.0 des Steckverbinders 10 auf. Der Innenleiter 1.3 mit der Kontaktzone 1.30 ist nur in Figur 3 dargestellt. Hierbei befindet sich die Kontaktzone 1.30 auf der Mantelfläche der bis auf die Rückseite R der Leiterplatte 1 geführten Innenbohrung 1.20. Auf der Rückseite R der Leiterplatte 1 geht der Innenleiter 1.3 in eine Leiterbahn 1.70 einer auf der Rückseite R der Leiterplatte 1 angeordneten Leiterbahnebene 1.7 über.

Der Boden 1.12 des Einsteckraums 1.10 ist eine Kreisringfläche, die über mehrere Kontaktbohrungen 1.13 mit der Rückseite R der Leiterplatte 1 verbunden ist (vgl. Figur 2).

Gemäß Figur 3 befindet sich eine zweite Kontaktzone 1.40 als Innenleiter 1.4 des Steckverbinderanschlusses 1.0 auf der äußeren Mantelfläche 1.11 des Einsteckraums 1.10 sowie teilweise auf dem Boden 1.12, so dass auch der Bereich der Kontaktbohrungen 1.13 überdeckt wird. Die Kontaktbohrungen 1.13 werden bis auf die Rückseite R der Leiterplatte 1 durchkontaktiert und mit einer Leiterbahn 1.71 der Leiterbahnebene 1.7 verbunden. Diese zweite Kontaktzone 1.40 wird mit dem Außenleiter 11.0 des Steckverbinders 10 elektrisch verbunden.

Zur direkten elektrischen mechanischen Verbindung des Steckverbinders 10 mit dem Steckverbinderanschluss 1.0 der Leiterplatte 1 wird das steckseitige Ende des Steckverbinders 10 mit der Kontaktzone 11.10 der Hülse 11 und dem Einsteckpin 12.1 des Innenleiterstiftes 12 in die Sacklochbohrung 1.1 des Steckverbinderanschlusses 1.0 eingeführt. Hierbei wird der Einsteckpin 12.1 von der Innenbohrung 1.20 und gleichzeitig die Kontaktzone 11.10 von dem Einsteckraum 1.10 aufgenommen. Hierbei erleichtern die Anfasungen 1.60 und 1.21 das manuelle Einführen des Steckverbinders 10 in die Sacklochbohrung 1.1.

Um sowohl eine gute elektrische Verbindung als auch eine sichere mechanische Verbindung zwischen dem Steckverbinder 10 und dem Steckverbinderanschluss 1.0 sicherzustellen, ist zum einen der Einsteckpin 12.1 des Innenleiterstiftes 12 kreuzförmigen geschlitzt, so dass federnde Kontaktarme 12.10 entstehen. Der Durchmesser der Innenbohrung 1.20 ist auf diese Kontaktarme 12.10 derart angepasst, dass beim Einführen des Einsteckpins 12.1 in die Innenbohrung 1.20 die Kontaktarme 12.10 gegen die Federkraft derselben zusammengedrückt werden.

Zum anderen ist die Weite W des kreisringzylindrischen Einsteckraums 1.10 in radialer Richtung an die Kontaktlaschen 11.11 der Kontaktzone 11.10 angepasst. Mehrere Kontaktlaschen 11.11, die jeweils durch in Längsrichtung des Steckverbinders 10 verlaufende Schlitze getrennt sind, sind zur Herstellung einer federnden Wirkung radial nach außen gespreizt und weisen endseitig einen umlaufenden Wulst auf. Mit dem Einführen dieser Kontaktzone 11.10 in den Einsteckraum 1.10 werden die Kontaktlaschen 11.11 unter Anliegen von deren Wulst an der zweiten Kontaktzone 1.40 radial gegen die Federkraft nach innen gedrückt.

Endseitig des ersten Dielektrikumsteilkörpers 13.1 ist eine Sacklochbohrung 13.10 vorgesehen, in die der Innenleiterstift 12 mit dem Einsteckpin 12.1 ragt. Ist der Steckverbinder 10 mit dem Steckverbinderanschluss 1.0 verbunden, ragt der Kontaktstift 1.2 in diese Sacklochbohrung 13.10.

Bei der in Figur 3 dargestellte Leiterplatte 1 befindet sich auf der Rückseite R die Leiterbahnebene 1.7 mit den Leiterbahnen 1.70 und 1.71. Diese Leiterbahnebene kann auch eine eingebettete Leiterbahnebene einer Mehrlagenleiterplatte darstellen.

### Bezugszeichenliste

- 1: Leiterplatte
- 1.0: Steckverbinderanschluss
- 1.1: Sacklochbohrung
- 1.10: kreisringzylindrischer Einsteckraum
- 1.11: äußeren Mantelfläche des Einsteckraums 1.10
- 1.12: Boden des Einsteckraums 1.10
- 1.13: Kontaktbohrung
- 1.2: Kontaktstift
- 1.20: Innenbohrung des Kontaktstiftes 1.2
- 1.21: Anfasung der Innenbohrung 1.20
- 1.3: Innenleiter
- 1.30: erste Kontaktzone
- 1.4: zweite Kontaktzone
- 1.40: Außenleiter
- 1.5: Kontaktabschnitt des Einsteckraums 1.10
- 1.6: Trichterabschnitt des Einsteckraums 1.10
- 1.60: Anfasung des Trichterabschnittes 1.6
- 1.7: Leiterbahnebene
- 1.70: Leiterbahn der Leiterbahnebene 1.7
- 1.71: Leiterbahn der Leiterbahnebene 1.7

- 10: Steckverbinder
- 11: Hülse des Steckverbinders 10
- 11.0: Außenleiter des Steckverbinders 10
- 11.1: Ausgleichsabschnitt des Hülse 11
- 11.10: Kontaktzone des Ausgleichsabschnittes 11.1
- 11.11: Kontaktlasche der Kontaktzone 11.10
- 11.2: Halteabschnitt der Hülse 11
- 11.20: Verbindungsflansch des Halteabschnittes 11.2
- 11.3: Biegeabschnitt der Hülse 11
- 11.31: Schlitz des Biegeabschnittes 11.3
- 11.32: Schlitz des Biegeabschnittes 11.3
- 12: Innenleiterstift
- 12.0: Innenleiter des Steckverbinders 10
- 12.1: Einsteckpin des Innenleiterstiftes 12
- 12.10: Kontaktarme des Einsteckpins 12.1
- 12.2: Querschnittsverjüngung des Innenleiterstiftes 12
- 13: Dielektrikumskörper des Steckverbinders 10
- 13.1: erster Dielektrikumsteilkörper
- 13.10: Sacklochbohrung des ersten Dielektrikumsteilkörpers 13.1
- 13.2: zweiter Dielektrikumsteilkörper
- 14: Innenhülse des Steckverbinders 10
- 15: Spalt

- 100: elektrische Steckverbinderanordnung

- R: Rückseite der Leiterplatte 1
- V: Vorderseite der Leiterplatte 1
- W: radiale Weite des kreisringzylindrischen Einsteckraums 1.0

## Patentansprüche

1. Leiterplatte (1) mit einem Steckverbinderanschluss (1.0) zur Direktkontaktierung mit einem Steckverbinder (10), wobei der Steckverbinderanschluss (1.0) auf der Vorderseite (V) der Leiterplatte (1) ausgebildet ist mit
- einem in einer Sacklochbohrung (1.1) unter Bildung eines kreisringzylinderischen Einsteckraums (1.10) zentrisch angeordneten Kontaktstift (1.2), welcher eine Innenbohrung (1.20) mit einer ersten Kontaktzone (1.30) eines Innenleiter (1.3) zur Kontaktierung eines Innenleiters (12.0) des Steckverbinders (10) aufweist, und
- einer in dem Einsteckraum (1.10) angeordneten zweiten Kontaktzone (1.40) eines Außenleiters (1.4) zur Kontaktierung eines Außenleiters (11.0) des Steckverbinders (10) .

2. Leiterplatte (1) nach Anspruch 1, bei welcher der Einsteckraum (1.10) einen Kontaktabschnitt (1.5) mit der zweiten Kontaktzone (1.40) und einen Trichterabschnitt (1.6) mit einer in Richtung der Vorderseite (V) der Leiterplatte (1) sich radial aufweitenden Anfasung (1.60) aufweist.

3. Leiterplatte (1) nach Anspruch 2, bei welcher der Kontaktstift (1.2) mit der Länge des Kontaktabschnittes (1.5) des Einsteckraums (1.10) ausgebildet ist.

4. Leiterplatte (1) nach einem der vorhergehenden Ansprüche, bei welcher der Innenleiter (1.4) auf eine zur Vorderseite (V) der Leiterplatte (1) gegenüberliegende Leiterbahnebene (1.7) geführt und mit einer Leiterbahn (1.70) der Leiterbahnebene (1.7) elektrisch verbunden ist.

5. Leiterplatte (1) nach einem der vorhergehenden Ansprüche, bei welcher die zweite Kontaktzone (1.40) zumindest auf der äußeren Mantelfläche (1.11) des kreisringzylindrischen Einsteckraums (1.10) angeordnet ist.

6. Leiterplatte (1) nach einem der vorhergehenden Ansprüche, bei welcher der Außenleiter (1.4) auf eine zur Vorderseite (V) der Leiterplatte (1) gegenüberliegende Leiterbahnebene (1.7) geführt und mit einer Leiterbahn (1.71) der Leiterbahnebene (1.7) elektrisch verbunden ist.

7. Leiterplatte (1) nach einem der vorhergehenden Ansprüche, bei welcher die Innenbohrung (1.20) des Kontaktstiftes (1.2) endseitig mit einer sich radial aufweitenden Anfasung (1.21) ausgebildet ist.

8. Leiterplatte (1) nach einem der vorhergehenden Ansprüche, bei welcher die radiale Weite (W) des kreisringzylindrischen Einsteckraums (1.10) zur Herstellung eines federnden Steckkontaktes an die den Außenleiter (11.0) des Steckverbinders (10) bildende Hülse (11) angepasst ist.

9. Elektrische Steckverbinderanordnung (100) mit einer Leiterplatte (1) nach einem der vorhergehenden Ansprüche und einem mit dem Steckverbinderanschluss (1.0) der Leiterplatte (1) verbundenen Steckverbinder (10), wobei
- zur Kontaktierung der ersten Kontaktzone (1.30) des Steckverbinderanschlusses (1.0) der Steckverbinder (10) einen als Innenleiterstift (12) ausgeführten Innenleiter (12.0) zum Einführen in die Innenbohrung (1.20) des Kontaktstiftes (1.2) des Steckverbinderanschlusses (1.0) aufweist,
- der Steckverbinder (10) einen als Hülse (11) ausgebildeten Außenleiter (11.0) mit einer Kontaktzone (11.10) zur Kontaktierung der zweiten Kontaktzone (1.40) des Steckverbinderanschlusses (1.0) aufweist, und
- der Steckverbinder (10) einen Dielektrikumskörper (13) mit einer Innenbohrung zur Aufnahme des Innenleiterstiftes (12) aufweist, wobei der Dielektrikumskörper (13) in der Hülse (12) angeordnet ist.

10. Elektrische Steckverbindung (100) nach Anspruch 9, bei welcher die Hülse (11) des Steckverbinders (10) am zur Kontaktzone (11.10) gegenüberliegenden Ende einen Verbindungsflansch (11.20) zur mechanischen Verbindung mit einer weiteren Leiterplatte aufweist.

## Claims

1. Circuit board (1) with a plug connector terminal (1.0) for direct contacting to a plug connector (10), wherein the plug connector terminal (1.0) is implemented on the front side (V) of the circuit board with
- a contact pin (1.2), centrally arranged within a blind bore (1.1) and thereby forming a circularly cylindrical insertion space (1.10), which comprises an inner bore (1.20), having a first contact zone (1.30) of an inner conductor (1.3) for the contacting of an inner conductor (12.0) of the plug connector (10), and
- a second contact zone (1.40) of an outer conductor (1.4), arranged in the insertion space (1.10), for the contacting of an outer conductor (11.0) of the plug connector (10).

2. Circuit board (1) in accordance with claim 1, in which the insertion space (1.10) comprises a contact section (1.5) to the second contact zone (1.40), and a funnel section (1.6), with a chamfer (1.60) which expands radially in the direction of the front side (V) of the circuit board (1).

3. Circuit board (1) in accordance with claim 2, in which the contact pin (1.2) is implemented in the length of the contact section (1.5) of the insertion space (1.10).

4. Circuit board (1) in accordance with any of the preceding claims, in which the inner conductor (1.4) is conducted onto a conductor track plane (1.7) disposed opposite the front side (V) of the circuit board (1) and is electrically connected to a conductor track (1.70) of the conductor track plane (1.7).

5. Circuit board (1) in accordance with any of the preceding claims, in which the second contact zone (1.40) is arranged on at least the outer casing surface (1.11) of the circularly cylindrical insertion space (1.10).

6. Circuit board (1) in accordance with any of the preceding claims, in which the outer conductor (1.4) is conducted onto a conductor track plane (1.7) disposed opposite the front side (V) of the circuit board (1) and is electrically connected to a conductor track (1.71) of the conductor track plane (1.7).

7. Circuit board (1) in accordance with any of the preceding claims, in which the inner bore (1.20) of the contact pin (1.2) is implemented at its end with a radially expanding chamfer (1.21).

8. Circuit board (1) in accordance with any of the preceding claims, in which the radial width (W) of the circularly cylindrical insertion space (1.10) is adapted to the outer conductor (11.0) of the sleeve (11) that forms the plug connector (10) to produce a resilient plug-in contact.

9. Electric plug connector arrangement (100), having a circuit board (1) in accordance with any of the preceding claims and with a plug connector (10) which is connected to the plug connector terminal (1.0) of the circuit board (1), wherein
- the plug connector (10) comprises an inner conductor (12.), implemented as an inner conductor pin (12), for insertion into the inner bore (1.20) of the contact pin (1.2) of the plug connector terminal (1.0) for contacting the first contact zone (1.30) of the plug connector terminal (1.0),
- the plug connector (10) comprises an outer conductor (11.0), implemented as a sleeve (11), with a contact zone (11.10) for contacting the second contact zone (1.40) of the plug connector terminal (1.0), and
- the plug connector (10) comprises a dielectric body (13) with an inner bore for receiving the inner conductor pin (12), wherein the dielectric body (13) is arranged in the sleeve (12).

10. Electric plug connector arrangement (100) in accordance with claim 9, in which the sleeve (11) of the plug connector (10) comprises a connection flange (11.20) at its end opposite the contact zone (11.10) for mechanical connection to a further circuit board.

## Revendications

1. Carte de circuit (1) comprenant un branchement de connecteur (1.0) pour le contact direct avec un connecteur (10), le branchement de connecteur (1.0) étant réalisé dans la face avant (V) de la carte de circuit (1) comprenant :
- une broche de contact (1.2) engagée de manière centrale dans un perçage borgne (1.1) formant un logement d'enfichage (1.10) cylindrique circulaire, cette broche ayant un perçage intérieur (1.20) avec une première zone de contact (1.30), d'un conducteur intérieur (1.3) pour la mise en contact d'un conducteur intérieur (12.0) du connecteur (10), et
- une seconde zone de contact (1.40) d'un conducteur extérieur (1.4) dans le logement d'enfichage (1.10), pour la mise en contact d'un conducteur extérieur (11.0) du connecteur (10).

2. Carte de circuit (1) selon la revendication 1,
dans laquelle
le logement d'enfichage (1.10) comprend un segment de contact (1.5) avec une seconde zone de contact (1.40) et un segment (1.6), en forme d'entonnoir ayant un chanfrein (1.60) s'étendant radialement en direction de la face avant (V) de la carte de circuit (1).

3. Carte de circuit (1) selon la revendication 2,
dans laquelle
la broche de contact (1.2) a la longueur du segment de contact (1.5) du logement d'enfichage (1.10).

4. Carte de circuit (1) selon l'une des revendications précédentes,
dans laquelle
le conducteur intérieur (1.3) arrivant dans le plan des chemins conducteurs (1.7) à l'opposé de la face avant (V) de la carte de circuit (1) est relié électriquement à un chemin conducteur (1.70) du plan des chemins conducteurs (1.7).

5. Carte de circuit (1) selon l'une des revendications précédentes,
dans laquelle
la seconde zone de contact (1.40) est prévue au moins sur la surface-enveloppe extérieure (1.11) du logement d'enfichage (1.10) cylindrique circulaire.

6. Carte de circuit (1) selon l'une des revendications précédentes,
dans laquelle
le conducteur extérieur (1.4) arrivant dans le plan des chemins conducteurs (1.7) à l'opposé de la face avant (V) de la carte de circuit (1) est relié électriquement à un chemin conducteur (1.71) du plan de chemin conducteur (1.7).

7. Carte de circuit (1) selon l'une des revendications précédentes,
dans laquelle
un côté du perçage intérieur (1.20) de la broche de contact (1.2) a un chanfrein (1.21) qui s'élargit radialement.

8. Carte de circuit (1) selon l'une des revendications précédentes,
dans laquelle
l'extension radiale (W) du logement d'enfichage (1.10) cylindrique circulaire est adapté au conducteur extérieur (11.0) du manchon (11) formant le connecteur (10) pour réaliser un contact d'enfichage élastique.

9. Dispositif de connecteur électrique (100) comportant une carte de circuit (1) selon l'une des revendications précédentes et un connecteur (10) relié à un branchement de connecteur (1.0) de la carte de circuit (1),
- pour la mise en contact de la première zone de contact (1.30) du branchement (1.0) du connecteur (10), un conducteur intérieur (12.0) réalisé comme broche de conducteur intérieur (12) pour l'engagement dans le perçage intérieur (1.20) de la broche de contact (1.2) du branchement de connecteur (1.10),
- le connecteur (10) a un conducteur extérieur (11.0) réalisé sous la forme d'un manchon (11) avec une zone de contact (11.10) pour la mise en contact de la seconde zone de contact (1.40) du branchement de connecteur (1.0), et
- le connecteur (10) a un corps diélectrique (13) avec un perçage intérieur pour recevoir la broche de conducteur intérieur (12), le corps de diélectrique (13) étant dans le manchon (12).

10. Dispositif de connecteur électrique (100) selon la revendication 9,
dans lequel
le manchon (11) du connecteur (10) comporte à l'extrémité opposée à la zone de contact (11,10), une bride de liaison (11.20) pour la liaison mécanique avec une autre carte de circuit.
